Europäisches Patentamt

European Patent Office

Office européen des brevets

(11) Veröffentlichungsnummer: **0 360 999**
**A2**

(12) # EUROPÄISCHE PATENTANMELDUNG

(21) Anmeldenummer: **89113255.7**

(51) Int. Cl.⁵: **G01R 31/28**

(22) Anmeldetag: **19.07.89**

(30) Priorität: **29.09.88 DE 3833160**

(43) Veröffentlichungstag der Anmeldung:
**04.04.90 Patentblatt 90/14**

(84) Benannte Vertragsstaaten:
**DE FR GB IT NL**

(71) Anmelder: **Siemens Aktiengesellschaft**
**Wittelsbacherplatz 2**
**D-8000 München 2(DE)**

(72) Erfinder: **Istavrinos, Petro, Dipl.-Math.**
**Prinz-Otto-Strasse 8**
**D-8012 Ottobrunn(DE)**
Erfinder: **Lutz, Karl, Dipl.-Math.**
**Feldstrasse 38**
**D-8044 Unterschleissheim(DE)**

(54) **Verfahren zur Erzeugung von Prüf-Bitmustern.**

(57) Verfahren zur Erzeugung von Prüf-Bitmustern zur Prüfung gefertigter digitaler Bausteine, bei dem vorgesehen ist, daß in einem ersten Schritt eine Logiksimulation des zu prüfenden Bausteintyps auf Gatterebene erstellt wird, mit der der betreffende Schaltkreisentwurf des Bausteins verifiziert worden ist, daß aus den funktionalen Bitmustern der erstellten Logiksimulation zeitlich gerasterte Eingangsbitmuster (MD-FTDL) erzeugt werden, wobei alle undefinierten Eingangsbits durch definierte Eingangsbits ersetzt werden, daß für die Eingangssignale des Bausteins verzögerungszeiten berechnet werden, indem das arithmetische Mittel der Verzögerung bezogen auf den angewendeten inneren Taktzyklus der benutzten Prüfeinrichtung- gebildet wird, daß Gruppen von Eingangssignalen gebildet werden, wobei die durchschnittliche Verzögerung der in einer Gruppe enthaltenen Signale die Verzögerung der Gruppe bestimmt und wobei die relativen Ereigniszeitpunkte in einem Zyklus bestimmt sind und ein Zeitraster für die Eingangsbits definiert ist, daß die funktionalen Bitmuster auf das Zeitraster abgebildet werden, wobei die Reihenfolge von auftretenden Signalwechseln erhalten bleibt, daß mit den zeitlich gerasterten Eingangsbitmustern eine erneute Simulation auf Gatterebene durchgeführt wird, wonach die entstehenden Ausgangssignale zu Gruppen zusammengefaßt werden, wobei alle zu einer Gruppe gehörenden Signale zu einem vorgegebenen Abtastzeitpunkt (Strobe) definiert sein müssen, und daß in einem letzten Schritt (MD-FUNCBIT) entstandene Eingangs- und Ausgangsbitmuster zu vollständigen Prüf-Bitmustern vorbestimmten Formats zusammengesetzt werden, wobei jeweils eine Konsistenzprüfung der Prüf-Bitmuster durchgeführt wird.

**FIG 1**

Bitmuster der Logiksimulation

MK-FTDL

Gerasterte Eingangsbitmuster und Eingangsgruppen

LOGIKSIMULATION

Ein-und Ausgangsbitmuster

MK-OUT
Definition der Ausgangsgruppen

MK-FUNCBIT

Testbitmuster im gewünschten Format

## Verfahren zur Erzeugung von Prüf-Bitmustern

Die Erfindung betrifft ein Verfahren zur Erzeugung von Prüf-Bitmustern zur Prüfung gefertigter digitaler Bausteine nach Patentanspruch 1.

Die Prüfung von gefertigten digitalen Bausteinen erfolgt im allgemeinen durch Anlegen von Eingangsbitmustern an den beteffenden Baustein und durch Vergleich der Ausgangssignale des Bausteins mit vorgegebenen Bitmustern. Bei einer herkömmlichen Prüftechnik erfolgt die Prüfung durch Prüfeinrichtungen, die die Bitmuster in einem festgelegten, zyklischen Zeitraster an die Eingänge der Prüfobjekte legen und die Ausgänge mit den Ausgangsbitmustern vergleichen. Ein Problem besteht bei dieser herkömmlichen Prüftechnik in der korrekten Erstellung der Prüf-Bitmuster, vor allem im Hinblick auf die Anforderungen der Prüfeinrichtungen. (Eingangs- bzw. Ausgangssignale müssen nämlich zu Gruppen zusammengefaßt werden, die zu einheitlichen Zeitpunkten im Prüfzyklus angelegt bzw. abgetastet werden.) Ferner sollen mit den Prüf-Bitmustern möglichst alle Funktionen des Bausteins überprüft werden.

Prüf-Bitmuster zur Prüfung der korrekten Arbeitsweise des fertigen Bausteins wurden bisher von Hand, beispielsweise durch den Entwickler, erstellt oder ohne Berücksichtigung der Schaltwerksfunktion und der Signallaufzeiten anhand einer Schaltwerksbeschreibung automatisch generiert.

Der vorliegenden Erfindung liegt die Aufgabe zugrunde, ein Verfahren der eingangs genannten Art zu schaffen, das auf einfache Art und Weise aus einem Bitmuster einer Logiksimulation des Prüfobjeks Prüf-Bitmuster erzeugt.

Zur Lösung dieser Aufgabe wird ein Verfahren der eingangs genannten Art und gemäß dem Oberbegriff des Patentanspruchs 1 vorgeschlagen, das durch die im kennzeichnenden Teil des Patenanspruchs 1 angegebenen Merkmale charakterisiert ist.

Vorteilhaft Weiterbildungen der Erfindung sind durch die in den Unteransprüchen angegebenen Merkmale gekennzeichnet.

Im folgenden wird die Erfindung anhand mehrerer Figuren beschrieben.

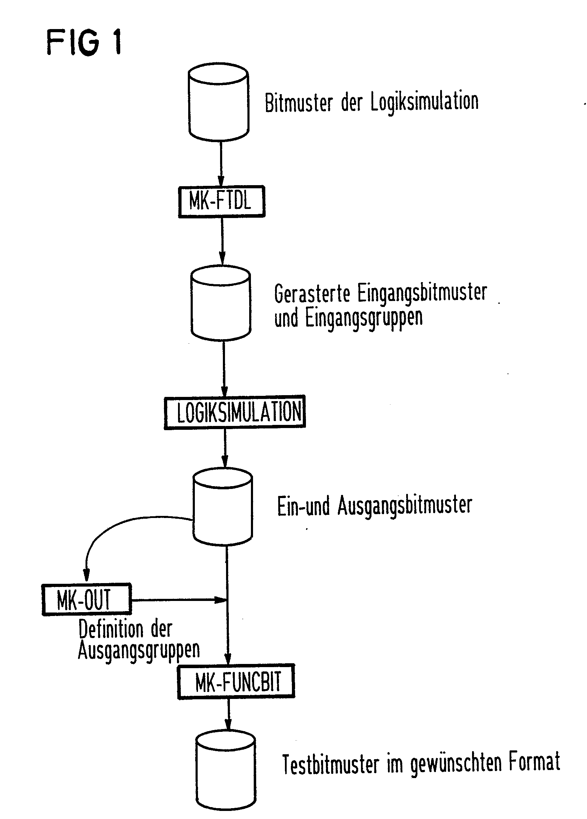

Fig. 1 zeigt einen schematischen Datenflußplan zur Erzeugung von Testbitmustern au einem Logiksimulations-Bitmuster.

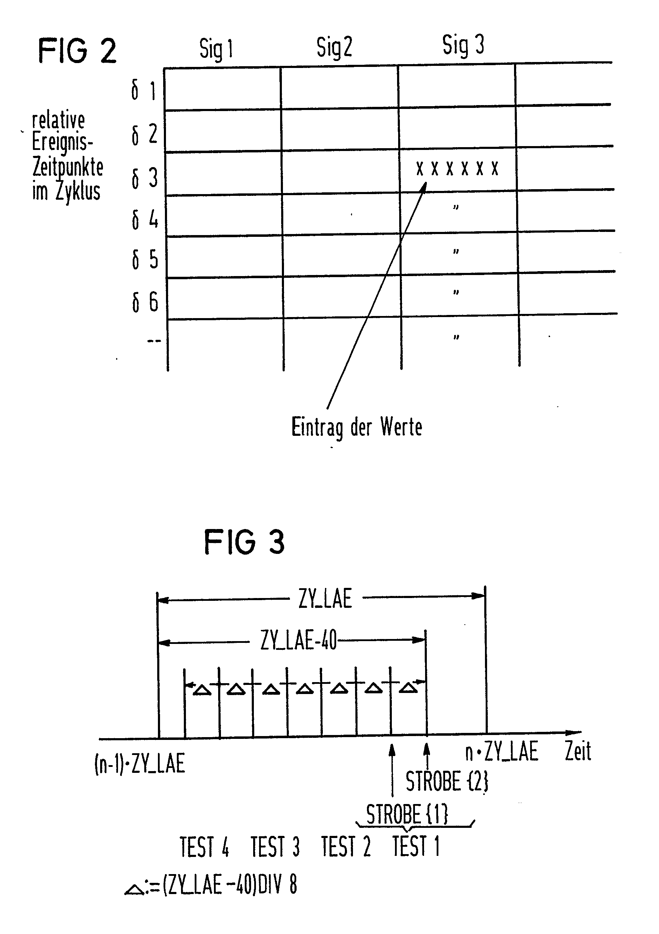

Fig. 2 zeigt eine schematische Darstellung zur Erzeugung von Eingangsbitmustern.

Fig. 3 zeigt ein schematisches Zeitdiagramm, aus dem die Definition von Testläufen und Strobes hervorgeht.

Gemäß der vorliegenden Lösung werden Testbitmuster zur Prüfung der Bausteine aus einer Logiksimulation auf Gatterebene gewonnen, mit der der Schaltwerksentwurf verifiziert wurde. Dazu werden zunächst aus den funktionalen Bitmustern der Logiksimulation zeitlich gerasterte Eingangsbitmuster erzeugt (MK-FTDL). Alle undefinierten Eingangsbits werden durch definierte ersetzt. Für die Eingangssignale werden Verzögerungszeiten berechnet, indem das arithmetische Mittel der Verzögerung, bezogen auf den internen Taktzyklus der Maschine, gebildet wird. Die Gruppen der Eingangssignale werden in zwei Schritten bestimmt:

a) Es wird eine Größe p bestimmt mit p = (Zykluslänge/Anzahl der freien Gruppen). Falls dann ein Signal in einer p-Umgebung von Signalen einer Gruppe liegt, wird es der betreffenden Gruppe zugeordnet.

b) Alle nichtzugeordneten Signale werden der Gruppe zugeordnet, von der sie den minimalen Abstand haben.

Die Verzögerung für die Gruppe bestimmt sich dann als durchschnittliche Verzögerung der in dieser Gruppe enthaltenen Signale. Damit sind die relativen Ereigniszeitpunkte in einem Zyklus bestimmt und das Zeitraster für die Eingangsbits definiert. Die funktionalen Bitmuster werden auf dieses Zeitraster abgebildet, wobei die Reihenfolge der Signalwechsel eingehalten wird. Mit den gerasterten Eingangsbitmustern wird eine erneute Simulation auf Gatterebene durchgeführt. Aufgrund dieser Simulation können dann bis zu vier komplette Testabschnitte erzeugt werden, indem die Ausgangssignale zu verschiedenen Zeitpunkten im Testzyklus überprüft werden (MK-OUT). Auch hier werden die Ausgangssignale zu Gruppen zusammengefaßt werden. Das Kriterium ist hierbei, daß alle Signale der Gruppe zu einem vorgegebenen Abtastzeitpunkt (Strobe) definiert sind. Enthält der Baustein bidirektionale Pad-Treiber, so müssen diese zu eigenen Gruppen zusammengefaßt werden. Der Wert des Treiber-Steuersignals je Zyklus bestimmt die Behandlung einer solchen Gruppe als Eingangsbzw. Ausgangsgruppe. In einem letzten Schritt (Mk-FUNCBIT) werden Eingangs- und Ausgangsbitmuster zu vollständigen Testbitmustern im gewünschten Format zusammengesetzt. Dabei werden umfangreiche Konsistenzprüfungen durchgeführt.

Je Prüfzyklus ermittelt das Verfahren aus der Simulation:
- die Betriebsrichtung jeder bidirektionalen Gruppe (Behandlung als Eingangs- oder Ausgangsgruppe)
- die Stimuliwerte für jede Eingangsgruppe zur vorgegebenen Zeit innerhalb eines Testzyklus
- die Werte aller Pins von Ausgangsgruppen und deren Verträglichkeit (gruppenweise, in einer Umgebung der vorgegebenen Abtastzeit).

Für eine Gruppe mit unbestimmten oder unverträglichen Werten wird die Abtastung durch den Testautomaten im aktuellen Testzyklus unterdrückt.

Die ermittelten Bitmuster werden als Datei mit spezifischem Format für den Testautomaten ausgegeben.

## Ansprüche

1. Verfahren zur Erzeugung von Prüf-Bitmustern zur Prüfung gefertigter digitaler Bausteine, **dadurch gekennzeichnet,**
- daß in einem ersten Schritt eine Logiksimulation des zu prüfenden Bausteintyps auf Gatterebene erstellt wird, mit der der betreffende Schaltkreisentwurf des Bausteins verifiziert worden ist,
- daß aus den funktionalen Bitmustern der erstellten Logiksimulation zeitlich gerasterte Eingangsbitmuster (MD-FTDL) erzeugt werden, wobei alle undefinierten Eingangsbits durch definierte Eingangsbits ersetzt werden,
- daß für die Eingangssignale des Bausteins Verzögerungszeiten berechnet werden, indem das arithmetische Mittel der Verzögerung - bezogen auf den angewendeten inneren Taktzyklus der benutzten Prüfeinrichtung - gebildet wird,
- daß Gruppen von Eingangssignalen gebildet werden, wobei die durchschnittliche Verzögerung der in einer Gruppe enthaltenen Signale die Verzögerung der Gruppe bestimmt und wobei die relativen Ereigniszeitpunkte in einem Zyklus bestimmt sind und ein Zeitraster für die Eingangsbits definiert ist,
- daß die funktionalen Bitmuster auf das Zeitraster abgebildet werden, wobei die Reihenfolge von auftretenden Signalwechseln erhalten bleibt,
- daß mit den zeitlich gerasterten Eingangsbitmustern eine erneute Simulation auf Gatterebene durchgeführt wird, wonach die entstehenden Ausgangssignale zu Gruppen zusammengefaßt werden, wobei alle zu einer Gruppe gehörenden Signale zu einem vorgegebenen Abtastzeitpunkt (Strobe) definiert sein müssen, und
- daß in einem letzten Schritt (MD-FUNCBIT) entstandene Eingangs-und Ausgangsbitmuster zu vollständigen Prüf-Bitmustern vorbestimmten Formats zusammengesetzt werden, wobei jeweils eine Konsistenzprüfung der Prüf-Bitmuster durchgeführt wird (Fig. 1).

2. Verfahren zur Erzeugung von Prüf-Bitmustern nach Anspruch 1, **dadurch gekennzeichnet,** daß bei der erneuten Simulation mehrere, vorzugsweise maximal vier vollständige Prüfabschnitte gebildet werden, indem die entstandenen Ausgangssignale zu verschiedenen Zeitpunkten im Prüfzyklus geprüft werden (MK-OUT, Fig. 1).

3. Verfahren zur Erzeugung von Prüf-Bitmustern nach Anspruch 1 oder 2, **dadurch gekennzeichnet,** daß in dem Fall, bei dem der zu prüfende Baustein bidirektionale Pad-Treiber enthält, diese im Prüfablauf zu eigenen Gruppe zusammengefaßt werden und daß der Wert des betreffenden Treiber-Steuersignals je Zyklus die Behandlung einer derartigen Gruppe als Eingangs-bzw. Ausgangsgruppe bestimmt.

4. Verfahren zur Erzeugung von Prüf-Bitmustern nach einem der Ansprüche 1 bis 3, **dadurch gekennzeichnet,** daß die Gruppen der Eingangssignale in zwei Schritten bestimmt werden, wobei in einem ersten Schritt eine Größe p mit p = (Zykluslänge/Anzahl der freien Gruppen) bestimmt wird und wobei, falls ein Signal in einer P-Umgebung von Signalen einer Gruppe liegt, dieses der betreffenden Gruppe zugeordnet wird, und in einem zweiten Schritt alle nichtzugeordneten Signale derjenigen Gruppe zugeordnet werden, von der sie den minimalen Abstand haben.

## FIG 1

Bitmuster der Logiksimulation

MK-FTDL

Gerasterte Eingangsbitmuster
und Eingangsgruppen

LOGIKSIMULATION

Ein-und Ausgangsbitmuster

MK-OUT

Definition der
Ausgangsgruppen

MK-FUNCBIT

Testbitmuster im gewünschten Format

## FIG 2

|  | Sig 1 | Sig2 | Sig 3 |  |
|---|---|---|---|---|
| δ 1 |  |  |  |  |
| δ 2 |  |  |  |  |
| δ 3 |  |  | x x x x x x |  |
| δ 4 |  |  | " |  |
| δ 5 |  |  | " |  |
| δ 6 |  |  | " |  |
| -- |  |  | " |  |

relative
Ereignis-
Zeitpunkte
im Zyklus

Eintrag der Werte

## FIG 3

$\triangle := (ZY\_LAE - 40) \, DIV \, 8$